(19) **Europäisches Patentamt / European Patent Office / Office européen des brevets**

(11) **EP 1 988 632 B1**

(12) **EUROPEAN PATENT SPECIFICATION**

(45) Date of publication and mention
of the grant of the patent:
**12.05.2010 Bulletin 2010/19**

(51) Int Cl.:
***H03K 17/082*** *(2006.01)*

(21) Application number: **08075321.3**

(22) Date of filing: **29.04.2008**

(54) **Control of a power semiconductor switch**

Steuerung eines Leistungshalbleiterschalters

Contrôle d'un interrupteur électrique à semi-conducteur

(84) Designated Contracting States:
**AT BE BG CH CY CZ DE DK EE ES FI FR GB GR
HR HU IE IS IT LI LT LU LV MC MT NL NO PL PT
RO SE SI SK TR**

(30) Priority: **30.04.2007 FI 20070337**

(43) Date of publication of application:
**05.11.2008 Bulletin 2008/45**

(73) Proprietor: **Vacon Oyj
65380 Vaasa (FI)**

(72) Inventor: **Paavo, Merilinna
FI-33100 Tampere (FI)**

(74) Representative: **Järveläinen, Pertti Tauno Juhani
et al
Heinänen Oy Patent Agency
Airport Plaza
Äyritie 8 D
01510 Vantaa (FI)**

(56) References cited:
**EP-A- 0 680 147      JP-A- 4 156 268
JP-A- 2007 104 805      US-B1- 6 335 608**

EP 1 988 632 B1

## Description

### Field of technology

The object of this invention is a gate control method and a gate control arrangement of a voltage-controlled power semiconductor switch, more particularly an IGBT transistor, in power electronics appliances, more particularly in frequency converters.

### Prior art

The aim of the control system of a power electronics appliance, such as a frequency converter, is to manage the output current so that it constantly remains within those limits according to which the power components are dimensioned. Malfunctions, particularly a short-circuit of the output connectors, are extremely stressful circumstances for power switches, which is a problem from the standpoint of both the dimensioning of the appliance and reliability.

In the case of a short-circuit of the output connectors, the current traveling via the switch components of the output stage rises to be high extremely quickly, as a result of which all the conducting power switches try to extinguish as quickly as possible after detection of the defect. Internal fault tripping diagnostics, however, always has a certain latency, as a consequence of which the short-circuit current can rise to many times that of the normal situation before initiation of the current disconnecting procedures.

A short-circuited circuit is normally very inductive, so therefore an alternative route of passage must always be found for the current disconnected by a switch component. Owing to the stray inductance caused by the internal structure of the appliance, disconnection of an overlarge current causes a higher than normal voltage peak over the switch components, which in an extreme case can result in exceedance of their maximum voltage and in the destruction of the appliance. The height of the voltage peak can be calculated with prior art using the following formula:

$$\hat{u} = L_s \times di/dt \qquad\qquad [1]$$

where $\hat{u}$ = height of voltage peak
$L_s$ = stray inductance
$di/dt$ = speed of change of the current of the inductance

A prior-art method for limiting a voltage peak is to connect a capacitor of an adequately high capacitance and low impedance as close as possible to the connectors of the power switch. The optimal location can be mechanically difficult, however, especially if the capacitor is large in size. Another prior-art method is to limit the switching speed of the IGBT transistor by means of a gate resistor. The larger the value of the gate resistance, the slower is the switching speed. Indeed, generally a larger gate resistor is used in extinguishing than in ignition, with which arrangement it is possible to limit the speed of change in the current to be disconnected and via that also the voltage peak caused by stray inductance.

Publication US5,986,484 discloses an IGBT control solution, in which the moment of change in the current is indicated in an extinguishing situation and according to it a different sized resistance or a voltage for the remaining time of current extinguishment is connected to the gate control circuit.

Publication US6,275,093 discloses an arrangement, in which when disconnecting a short-circuit current the level of the positive control voltage of the IGBT decreases for a period of a few $\mu$s to a second reduced positive control voltage level before connection of the final negative control voltage corresponding to the extinguishing situation (two-level turn-off). With this arrangement the speed of change in the voltage effective over the IGBT and the overvoltage peak can be limited without a different sized gate resistor.

The drawbacks of prior-art solutions are, among others, the aforementioned difficulty in placement of the capacitor, its cost and the more complex structure and cost of the control circuit connected with a different sized gate resistor. The drawback of a two-level turn-off arrangement is that the suitable reduced control voltage level varies with different IGBTs, the suitable level depends on the temperature of the IGBT and a reduced level that is too long produces extra losses in the component and through that reduces the reliability.

### Summary of the invention

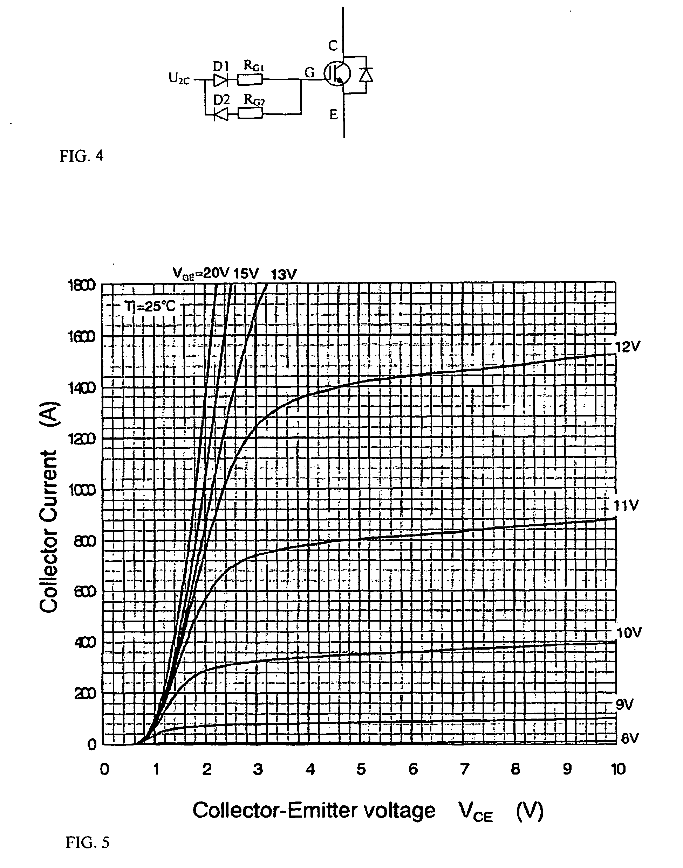

With the gate control according to this invention the voltage peak of a fault situation can be limited without the drawbacks associated with prior-art solutions. In the initial stage of the current disconnection situation the gate voltage produced by the control circuit according to the new solution decreases either linearly or exponentially, however remaining positive, for at least as long as the voltage over the IGBT increases and the highest voltage peak has passed. Only after that does the gate voltage decrease rapidly to its final negative level of the non-conductive state. During the decreasing gate voltage of the initial stage the IGBT functions in a so-called linear range (see Fig. 5), in which case the voltage effective over it increases. A large part of a short-circuit current passes on through the IGBT, as a result of which only the remaining part of the short-circuit current switches to the new current path, of which the voltage peak caused by stray inductance remains in that case smaller compared to a conventional control in which the gate voltage decreases immediately to the negative level.

In the initial stage of the current disconnection the advantage of a continuous change of gate voltage according to the new solution compared to the solution of publication US6,275,093 is that it is not necessary to know exactly the optimal gate voltage level according to the IGBT type nor to change the control circuit according to it. In addition, continuous reduction of the voltage results also in the current traveling through the IGBT decreasing continuously for the whole period of the entire initial stage, which has a significant reducing effect on the dissipated energy pulse absorbed by the IGBT in the situation and on the subsequent rise in temperature. For the sake of reliability, a rise in temperature is preferably to be kept as low as possible.

The amplitude control of gate voltage according to the invention can be implemented e.g. with analog reference and amplifying circuits, in which the measured gate voltage is compared to an internal reference level. A variable reference level can be adjusted, e.g. with a PWM control, under the control of the control unit of the frequency converter. The duration of the decreasing gate voltage can be fixed or it can be controlled by the control unit of the appliance.

The control arrangement according to the invention increases the reliability of the appliance in fault situations.

## Short description of the drawings

In the following, the invention will be described in more detail by the aid of some embodiments with reference to the attached drawings, wherein

Fig. 1 presents the main circuit of a frequency converter,
Fig. 2 presents an example of a significant part of the main circuit in a short-circuit situation,
Fig. 3 presents some typical waveforms of the signals relating to the switching of certain IGBTs in a situation of current disconnection with a prior-art control,
Fig. 4 presents a prior-art gate resistor arrangement of an IGBT,
Fig. 5 presents the effect of gate voltage on the conductive state of an IGBT,
Fig. 6 presents the control voltages of a gate according to the invention and according to prior art,
Fig. 7 presents some waveforms of the signals relating to the switching of certain IGBTs with a gate control according to the invention, and
Fig. 8 presents a conceptual implementation of a gate control circuit according to the invention.

## Detailed description of the invention

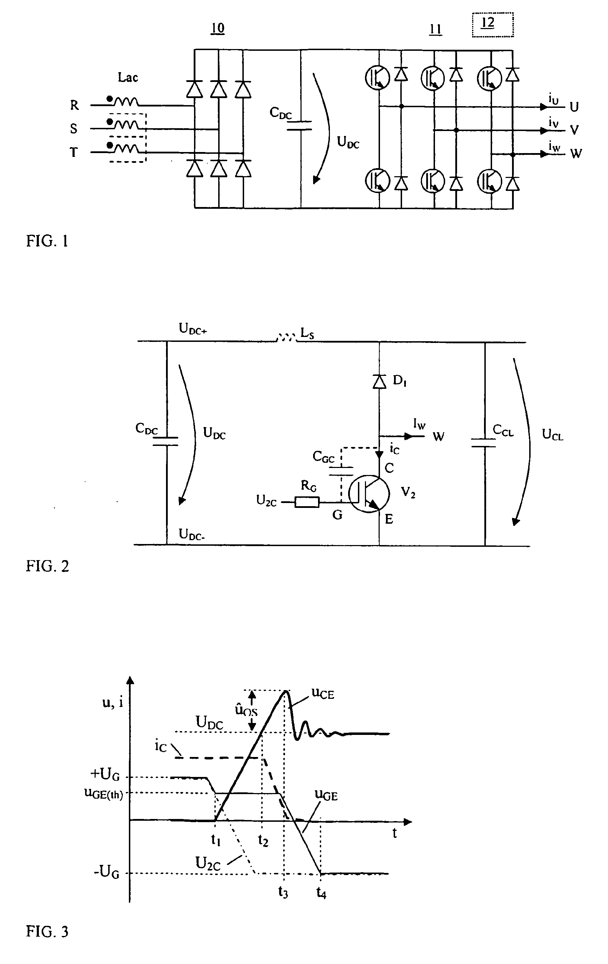

Fig. 1 presents an example of the main circuit of a normal three-phase PWM frequency converter, in which is a three-phase supply voltage R, S, T, an AC choke Lac for limiting the harmonics of the mains current, a network bridge 10 comprised of diodes for rectifying the three-phase alternating voltage of the supply network into the DC voltage $U_{DC}$ of the DC intermediate circuit which is filtered with a filtering capacitor $C_{DC}$, a load bridge 11 comprised of three phase switches implemented with power semiconductors, which forms the three-phase output voltage U, V, W from the DC voltage of the intermediate circuit, and a control unit 12. In modern frequency converters the phase switches are generally implemented with IGBT transistors according to the example of the figure, in parallel with which so-called zero diodes are connected. This invention relates e.g. to the control of this kind of load bridge implemented with IGBT transistors.

In a short-circuit of the output phases, e.g. in a situation in which the top branch of the U-phase and the bottom branch of the W-phase are conducting and a short-circuit forms between these phases, disconnection of the short-circuit current requires that the power semiconductor switches that are conducting are controlled to the non-conductive state. A summary of the essential components in this situation from the standpoint of the power switch of the bottom branch of the W-phase is presented in Fig. 2. The figure shows the IGBT transistor V2 of the bottom branch, the poles of which are the gate G, the collector C and the emitter E, the zero diode D1 of the top branch and the filtering capacitor $C_{DC}$, the voltage of which is $U_{DC}$, of the DC intermediate circuit. The structural stray inductances of the load bridge are for the sake of simplicity drawn in the figure centralized into a single stray inductance $L_s$ between $C_{DC}$ and the load bridge. Owing to the stray inductances, the voltage peaks occurring in switching situations are normally limited with the so-called chopper capacitor $C_{CL}$ of the figure, the voltage of which is $U_{CL}$, connected over the load bridge. It is endeavored to dispose this capacitor as close as possible (= producing low inductance) to the terminals of the IGBT module. The figure also presents the control voltage $U_{2c}$ linked to the potential of the emitter E, which is connected to the gate G of the IGBT transistor via the gate resistance $R_G$, as well as the internal so-called Miller capacitance $C_{GC}$ of the IGBT, drawn as a separate component, which has an essential effect on the switching event as described below.

Fig. 3 presents some typical waveforms relating to the circuit according to Fig. 2 in a situation of current disconnection. In the figure all voltages are presented against the potential of the emitter E. In the initial situation the IGBT of the lower branch conducts and the current $i_w$ of the W-phase is negative (i.e. the control signal $U_{2C}$ of the IGBT of the lower branch is positive and the current $i_c$ traveling through V2 from the collector to the emitter is also positive). Disconnection of the current starts when the control signal $U_{2C}$ of V2 starts to become negative towards the value - $U_G$. The gate voltage $u_{GE}$ of V2 always follows the $V_{2C}$ signal until the point at which it achieves the current-dependent threshold voltage level $u_{GE(th)}$ (e.g. approx. 7V) at the moment $t_1$. In this case the voltage $u_{CE}$ effective over V2 starts to grow at a rate that is limited and depends according to prior art on the magnitudes of the Miller capacitance $C_{GC}$ and of the external gate resistance $R_G$. The rate determines the current supplied by the capacitance to the gate resistor, the magnitude of which is presented by both sides of equation (2):

$$C_{GC} \times \frac{du_{CE}}{dt} = \frac{(u_{GE(th)} - (-U_G))}{R_G} \qquad [2]$$

As long as the voltage rises, the current caused by the charging of the Miller capacitance keeps the effective voltage $u_{GE}$ at the gate G broadly at the constant value $u_{GE(th)}$ (= up until the moment in time $t_3$). When the voltage has risen to the voltage level $U_{DC}$ of the intermediate circuit at the moment $t_2$, the diode D1 becomes conductive, in which case its current starts to grow and the current $i_c$ of V2 correspondingly decreases. Owing to the stray inductance $L_s$, the current switched to D1 causes an exceedance of voltage over the IGBT. After reaching the peak value $U_{DC} + û_{OS}$ the charging phenomenon of the Miller capacitance no longer keeps the gate voltage positive, so that it is able to decrease to the negative level (- $V_G$) set by the external control by the time $t_4$. Especially with large currents the voltage peak $U_{DC} + û_{OS}$ can rise dangerously high, for which reason it is normal to connect an additional capacitor $C_{CL}$ as near to the connectors of the IGBTs as possible.

In order to limit the voltage peak it is prior art to use also a gate resistor of a different size for ignition and extinguishing, e.g. according to Fig. 4. As a result of the increase of the resistance value $R_{G2}$ on the extinguishing side, a smaller speed of rise in voltage is sufficient to supply adequate Miller capacitance current to maintain the gate voltage at the threshold level, in which case there is correspondingly more time for transferring current from the IGBT to the zero diode, which reduces the exceedance $û_{OS}$ of voltage.

Fig. 5 presents an example of the dependency between the gate voltage of the IGBT and the collector current, which is the basis for the control function according to this invention. As can be seen from the figures, with low gate voltages a certain maximal collector current corresponds to each value of the gate voltage, with larger values of current than which the collector-emitter voltage rises steeply thus preventing an increase in current. In this case the IGBT is in a so-called linear operating range. Normally the gate voltage is controlled to be sufficiently high, e.g. to a value of 15V, for the collector voltage to achieve its minimum value and through this to minimize losses. In this case the IGBT operates in a so-called saturation state.

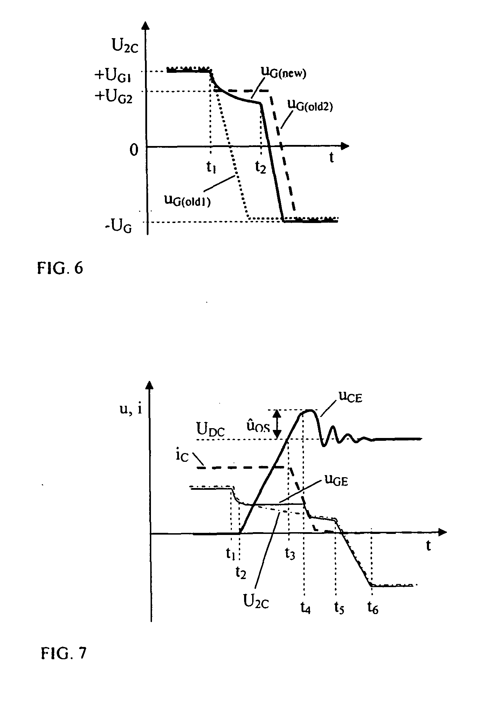

Fig. 6 presents an example of the voltage $U_{2C}$ of the gate control circuit according to the invention as well as two prior-art solutions for comparison purposes. In the new control method, which in the figure is named $u_{G(new)}$, the control voltage starts to decrease from the control level $+U_{G1}$ of the conductive state beginning from the start time $t_1$ of the current disconnection control either linearly or exponentially up until moment $t_2$, by which time the voltage effective over the IGBT has passed its peak value, after which it decreases to the negative control voltage -$U_G$ of the non-conductive state. In the prior-art control methods presented in the figure, the voltage $U_{2C}$ is controlled either immediately to its negative control voltage ($u_{G(old1)}$) or it is kept for a certain time at the reduced positive constant value $+U_{G2}$ before switching to the negative control level ($u_{G(old2)}$).

Fig. 7 presents the same theoretical waveforms of the current disconnection situation relating to the circuit of Fig. 2 with the control according to the invention as in Fig. 6. The initial situation is the same, and disconnection of the current starts when the value of the control signal $U_{2C}$ of V2 starts to decrease at the moment $t_1$. In this example the voltage decreases exponentially, remaining however positive and mainly in the range in which the IGBT is in the linear operating range. The collector voltage $u_{CE}$ starts to rise at the moment $t_2$, in which case the control voltage $U_{2c}$ falls below the gate voltage level corresponding to the collector current $i_c$. After this the current supplied by the Miller capacitance maintains the gate voltage $u_{GE}$ roughly at a constant value although the control voltage $U_{2C}$ continues its decline. At the moment $t_3$ the collector voltage reaches the voltage $U_{DC}$ of the intermediate circuit in which case the current of the IGBT starts to decrease in accordance with the load current switching to the upper branch via the zero diode.

A difference in the switching of the current to the top branch and via that also in the formation of the voltage peak compared to the example of Fig. 3 is now that since the voltage difference [$u_{GE}$ - $U_{2C}$] at the moment $t_3$ is significantly

smaller, the current of the gate resistance $R_G$ is also correspondingly smaller, which means that the speed of change in the collector voltage, which produces the relevant current of the gate resistance via the Miller capacitance, is also correspondingly smaller. A smaller speed of change in voltage means correspondingly also a smaller voltage peak $\hat{u}_{OS}$, which is exactly what is aimed for with the new control arrangement.

After the highest collector voltage peak has passed at the moment $t_4$, the Miller capacitance stops supplying current to the gate resistor, so that the gate voltage $u_{GE}$ decreases to the level of the external control voltage $U_{2C}$ which continues its decrease further to reduce the collector current and the dissipated energy pulse produced in the situation. At the time $t_5$ according to the figure at which the highest voltage peak has definitely passed, the control voltage starts to decrease towards its final level of the non-conductive state.

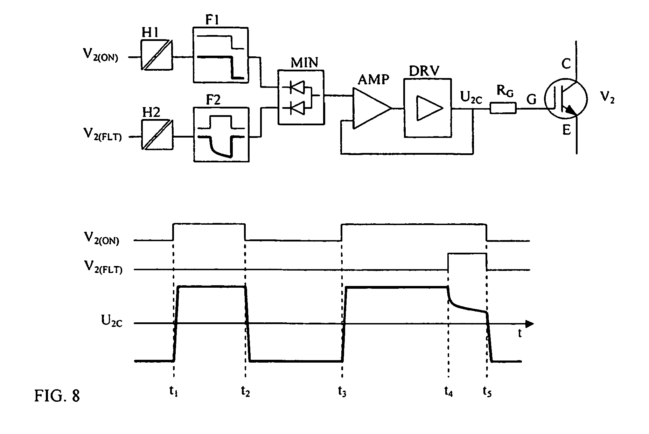

Fig. 8 presents a simplified block diagram level example of an implementation of a gate circuit according to the invention. The detailed implementation of the blocks can be done in many manners obvious to a person skilled in the art, so that it is not appropriate to go to that level in this context. The markings of the figure are as follows:

- $V_{2(ON)}$ is the control signal of the IGBT according to normal operation
- $V_{2(FLT)}$ is the control signal of the IGBT of a fault situation
- H1, H2 are the galvanic separators of the control signals
- F1, F2 are function blocks relating to the control signals
- MIN is the selector of the smallest value
- AMP is the amplifier
- DRV is the gate driver, which amplifies the AMP block signal

The more important signals relating to the function of a block are presented in the bottom part of the figure.

- During normal operation the output signal $U_{2C}$ follows the control signal $V_{2(ON)}$ (a pulse with the time interval $t_1 - t_2$) e.g. in the voltage range [- 15V...+15V].
- In a fault situation the control signal $V_{2(FLT)}$ activates, in which case the MIN block selects as the reference the decreasing voltage level formed by the F2 block which is further amplified into the output signal $U_{2C}$ of the driver (time interval $t_4 - t_5$)
- after a set time both control signals end, in which case $U_{2c}$ is controlled to the negative level of the non-conductive state owing to the reference signal formed by the F1 and MIN blocks (at time $t_5$).

It is obvious to the person skilled in the art that the different embodiments of the invention are not limited solely to the example described above, but that they may be varied within the scope of the claims presented below.

**Claims**

1.  Method for controlling the gate control voltage ($U_{2C}$) of voltage-controlled power semiconductor components (V2), such as IGBT transistors, used in power electronics appliances in a fault situation, such as in a situation of short-circuit of the output connectors of a frequency converter,
    in which method the gate control voltage ($U_{2C}$) of the power semiconductor component (V2) is decreased before the connection of the negative gate control voltage intended to extinguish the power semiconductor switch in order to minimize the voltage peak of the voltage over the power semiconductor component, such as the collector voltage.
    **characterized in that**
    the gate control voltage ($U_{2C}$) is decreased before the connection of the negative gate control voltage intended to extinguish the power semiconductor switch such that,
    its level decreases constantly, and
    it remains positive, and
    the gate control voltage ($U_{2C}$) is decreased thus until at least the first voltage peak over the component, especially the collector-emitter voltage peak, has passed.

2.  Method according to claim 1,
    **characterized in that** the gate control voltage ($U_{2C}$) is controlled to decrease such that the power semiconductor component (V2) operates at least mainly in the linear operating range from the time of the decreasing positive gate control voltage.

3.  Method according to claim 1 or 2,
    **characterized in that** the gate control voltage ($U_{2C}$) is controlled to decrease linearly.

**4.** Method according to claim 1 or 2,
**characterized in that** the gate control voltage ($U_{2C}$) is controlled to decrease exponentially.

**5.** Method according to any of claims 1-4,
**characterized in that** the duration of the gate control voltage decreasing thus is fixed.

**6.** Method according to any of claims 1-4,
**characterized in that** the duration of the gate control voltage decreasing thus is controlled by the control unit.

**7.** Arrangement for controlling the gate control voltage ($U_{2C}$) of voltage-controlled power semiconductor components (V2), such as IGBT transistors, used in power electronics appliances in a fault situation, such as in a situation of short-circuit of the output connectors of a frequency converter,
which arrangement is fitted to decrease the gate control voltage ($U_{2C}$) of the power semiconductor component (V2) before the connection of the negative gate control voltage intended to extinguish the power semiconductor switch in order to minimize the voltage peak of the voltage over the power semiconductor component, such as the collector voltage,
**characterized in that** the arrangement is fitted
to decrease the gate control voltage ($U_{2C}$) before the connection of the negative gate control voltage intended to extinguish the power semiconductor switch such that
its level decreases constantly, and
it remains positive, and
to decrease the gate control voltage ($U_{2C}$) thus until at least the first voltage peak over the component, especially the collector-emitter voltage peak, has passed.

**8.** Arrangement according to claim 7,
**characterized in that** the arrangement is an amplitude controller of the gate control voltage, which contains a reference circuit, which is fitted to compare the measured gate control voltage to an internal reference level.

**9.** Arrangement according to claim 7 or 8,
**characterized in that** the arrangement contains a variable reference level, which can be adjusted, e.g. with a PWM control, under the control of the control unit of the frequency converter.

**10.** Arrangement according to claim 7, 8 or 9,
**characterized in that** in the arrangement
during normal operation the output signal ($U_{2C}$) of the controller of the component is fitted to follow a normal operation control signal ($V_{2(ON)}$),
in a fault situation a fault situation control signal ($V_{2(FLT)}$) is fitted to be active, in which case the arrangement selects the decreasing voltage level as the reference, which can be further amplified into the output signal ($U_{2C}$) of the controller, and
in which on the ending of both control signals after a set period of time the output signal ($U_{2C}$) of the controller can be controlled to the negative level of the non-conductive state.

**11.** Arrangement according to any of claims 7 - 10,
**characterized in that** the arrangement's appliance is a PWM frequency converter, in which is a network bridge (10) for rectifying the three-phase alternating voltage of the supply network into the DC voltage ($U_{DC}$) of the intermediate circuit, a filtering capacitor ($C_{DC}$) in the DC intermediate circuit , a load bridge (11), with which the output voltage can be formed from the DC voltage of the intermediate circuit, as well as a control unit (12), and in which at least the load bridge and preferably also the network bridge comprise phase switches implemented with gate voltage controlled power semiconductor components (V2).

**Patentansprüche**

**1.** Verfahren zum Steuern der Gate-Steuerspannung ($U_{2C}$) spannungsgesteuerter Leistungshalbleiter-Komponenten (V2), wie zum Beispiel Bipolartransistoren mit isolierter Gate-Elektrode, die in LeistungsElektronik-Geräten eingesetzt werden, in einer Fehlersituation, wie zum Beispiel in einer Situation eines Kurzschlusses der Ausgangsanschlüsse eines Frequenzumsetzers,
wobei bei diesem Verfahren die Gate-Steuerspannung ($U_{2C}$) der Leistungshalbleiter-Komponente (V2) vor dem Anlegen der negativen Gate-Steuerspannung, die den Leistungshalbleiter-Schalter ausschalten soll, verringert wird, um die Spannungsspitze der an der Leistungshalbleiter-Komponente anliegenden Spannung, wie zum Beispiel der Kollektor-Spannung, zu minimieren,
**dadurch gekennzeichnet, dass**
die Gate-Steuerspannung ($U_{2C}$) vor dem Anlegen der negativen Gate-Steuerspannung, die den Leistungshalbleiter-Schalter ausschalten soll, verringert wird, so dass
ihr Pegel konstant verringert wird, und
sie positiv bleibt, und
die Gate-Steuerspannung ($U_{2C}$) auf diese Weise verringert wird, bis mindestens die erste Spannungsspitze an der Komponente, insbesondere die Kollektor-Emitter-Spannungsspitze, vorbei ist.

2. Verfahren nach Anspruch 1,
**dadurch gekennzeichnet, dass** die Gate-Steuerspannung ($U_{2C}$) so zur Verringerung gesteuert wird, dass die Leistungshalbleiter-Komponente (V2) von der Zeit der geringer werdenden positiven Gate-Steuerspannung an mindestens hauptsächlich im linearen Betriebsbereich arbeitet.

3. Verfahren nach Anspruch 1 oder 2,
**dadurch gekennzeichnet, dass** die Gate-Steuerspannung ($U_{2C}$) zur linearen Verringerung gesteuert wird.

4. Verfahren nach Anspruch 1 oder 2,
**dadurch gekennzeichnet, dass** die Gate-Steuerspannung ($U_{2C}$) zur exponentiellen Verringerung gesteuert wird.

5. Verfahren nach einem der Ansprüche 1 bis 4,
**dadurch gekennzeichnet, dass** die Dauer der auf diese Weise geringer werdenden Gate-Steuerspannung festgelegt ist.

6. Verfahren nach einem der Ansprüche 1 bis 4,
**dadurch gekennzeichnet, dass** die Dauer der auf diese Weise geringer werdenden Gate-Steuerspannung durch die Steuerungseinheit gesteuert wird.

7. Anordnung zum Steuern der Gate-Steuerspannung ($U_{2C}$)
spannungsgesteuerter Leistungshalbleiter-Komponenten (V2), wie zum Beispiel Bipolartransistoren mit isolierter Gate-Elektrode, die in LeistungsElektronik-Geräten eingesetzt werden, in einer Fehlersituation, wie zum Beispiel in einer Situation eines Kurzschlusses der Ausgangsanschlüsse eines Frequenzumsetzers,
wobei die Anordnung dazu eingerichtet ist, die Gate-Steuerspannung ($U_{2C}$) der Leistungshalbleiter-Komponente (V2) vor dem Anlegen der negativen Gate-Steuerspannung, die den Leistungshalbleiter-Schalter ausschalten soll, zu verringern, um die Spannungsspitze der an der Leistungshalbleiterkomponente anliegenden Spannung, wie zum Beispiel der Kollektor-Spannung, zu minimieren,
**dadurch gekennzeichnet, dass** die Anordnung dazu eingerichtet ist,
die Gate-Steuerspannung ($U_{2C}$) vor dem Anlegen der negativen Gate-Steuerspannung, die den Leistungshalbleiter-Schalter ausschalten soll, zu verringern, so dass
ihr Pegel konstant verringert wird, und
sie positiv bleibt, und
die Gate-Steuerspannung ($U_{2C}$) auf diese Weise zu verringern, bis mindestens die erste Spannungsspitze an der Komponente, insbesondere die Kollektor-Emitter-Spannungsspitze, vorbei ist.

8. Anordnung nach Anspruch 7,
**dadurch gekennzeichnet, dass** die Anordnung eine Amplitudensteuerung der Gate-Steuerspannung ist, die eine Referenzschaltung enthält, die dazu eingerichtet ist, die gemessene Gate-Steuerspannung mit einem internen Referenzpegel zu vergleichen.

9. Anordnung nach Anspruch 7 oder 8,
**dadurch gekennzeichnet, dass** die Anordnung einen variablen Referenzpegel enthält, der z.B. mit einer Pulsdauermodulationssteuerung unter der Steuerung der Steuereinheit des Frequenzumsetzers eingestellt werden kann.

10. Anordnung nach Anspruch 7, 8 oder 9,
**dadurch gekennzeichnet, dass** bei der Anordnung
während des Normalbetriebs das Ausgangssignal ($U_{2C}$) der Steuerung der Komponente dazu eingerichtet ist, einem Normalbetriebs-Steuersignal (V$_{2(ON)}$) zu folgen,
in einer Fehlersituation ein Fehlersituations-Steuersignal (V$_{2(FLT)}$) dazu eingerichtet ist, aktiv zu sein, wobei in diesem Fall die Anordnung den sich verringernden Spannungspegel als die Referenz auswählt, der weiter in das Ausgangssignal (U$_{2C}$) der Steuerung verstärkt werden kann, und
wobei am Ende beider Steuersignale nach einem festgelegten Zeitraum das Ausgangssignal (U$_{2C}$) der Steuerung auf den negativen Pegel des nicht leitenden Zustands gesteuert werden kann.

11. Anordnung nach einem der Ansprüche 7 bis 10,
**dadurch gekennzeichnet, dass** das Gerät der Anordnung ein Pulsdauermodulations-Frequenzumsetzer ist, in dem sich eine Netzbrücke (10) zum Gleichrichten des Drehstroms des Versorgungsnetzes in die Gleichspannung (U$_{DC}$) der Zwischenschaltung, ein Filterkondensator (C$_{DC}$) in der Gleichstrom-Zwischenschaltung, eine Lastbrücke (11), mit der die Ausgangsspannung von der Gleichspannung der Zwischenschaltung aus umgeformt werden kann, sowie eine Steuereinheit (12) befindet, und in dem mindestens die Lastbrücke und vorzugsweise auch die Netzbrücke Phasenschalter umfassen, die als gatespannungsgesteuerte Leistungshalbleiter-Komponenten (V2) implementiert sind.

**Revendications**

1. Procédé de commande de la tension de commande de grille (U$_{2C}$) de composants semi-conducteurs de puissance commandés par tension (V2), tels que des transistors IGBT, utilisés dans des appareils électroniques de puissance dans une situation de défaut, par exemple dans une situation de court-circuit des connecteurs de sortie d'un convertisseur de fréquence,
dans lequel procédé la tension de commande de grille (U$_{2C}$) du composant semi-conducteur de puissance (V2) est diminuée avant la connexion de la tension de commande de grille négative destinée à éteindre le commutateur à semi-conducteurs de puissance afin de réduire à un minimum le pic de tension de la tension sur le composant semi-conducteur de puissance, telle que la tension de collecteur,
**caractérisé en ce que**
la tension de commande de grille (U$_{2C}$) est diminuée avant la connexion de la tension de commande de grille négative destinée à éteindre le commutateur à semi-conducteurs de puissance de sorte que
son niveau diminue constamment, et
elle reste positive, et
la tension de commande de grille (U$_{2C}$) est diminuée ainsi jusqu'à ce qu'au moins le premier pic de tension sur le composant, particulièrement le pic de tension collecteur-émetteur, soit passé.

2. Procédé selon la revendication 1,
**caractérisé en ce que** la tension de commande de grille (U$_{2C}$) est commandée pour diminuer de sorte que le composant semi-conducteur de puissance (V2) fonctionne au moins principalement dans la plage de fonctionnement linéaire à partir de l'instant de la diminution de la tension de commande de grille positive.

3. Procédé selon la revendication 1 ou 2,
**caractérisé en ce que** la tension de commande de grille (U$_{2C}$) est commandée pour diminuer linéairement.

4. Procédé selon la revendication 1 ou 2,
**caractérisé en ce que** la tension de commande de grille (U$_{2C}$) est commandée pour diminuer exponentiellement.

5. Procédé selon l'une quelconque des revendications 1 à 4,
**caractérisé en ce que** la durée de la diminution de la tension de commande de grille est ainsi fixe.

6. Procédé selon l'une quelconque des revendications 1 à 4,
**caractérisé en ce que** la durée de la diminution de la tension de commande de grille est ainsi commandée par l'unité de commande.

7. Agencement pour commander la tension de commande de grille (U$_{2C}$) de composants semi-conducteurs de puissance commandés par tension (V2), tels que des transistors IGBT, utilisés dans des appareils électroniques de puissance dans une situation de défaut, par exemple dans une situation de court-circuit des connecteurs de sortie d'un convertisseur de fréquence,
lequel agencement est réglé pour diminuer la tension de commande de grille (U$_{2C}$) du composant semi-conducteur de puissance (V2) avant la connexion de la tension de commande de grille négative destinée à éteindre le commutateur à semi-conducteurs de puissance afin de réduire à un minimum le pic de tension de la tension sur le composant semi-conducteur de puissance, telle que la tension de collecteur,

**caractérisé en ce que** l'agencement est réglé

pour diminuer la tension de commande de grille ($U_{2C}$) avant la connexion de la tension de commande de grille négative destinée à éteindre le commutateur à semi-conducteurs de puissance de sorte que

son niveau diminue constamment, et

elle reste positive, et

pour diminuer la tension de commande de grille ($U_{2C}$) ainsi jusqu'à ce qu'au moins le premier pic de tension sur le composant, particulièrement le pic de tension collecteur-émetteur, soit passé.

8. Agencement selon la revendication 7,

**caractérisé en ce que** l'agencement est un contrôleur d'amplitude de la tension de commande de grille, qui contient un circuit de référence, qui est réglé pour comparer la tension de commande de grille mesurée à un niveau de référence interne.

9. Agencement selon la revendication 7 ou 8,

**caractérisé en ce que** l'agencement contient un niveau de référence variable, qui peut être réglé, par exemple par une commande PWM, sous la commande de l'unité de commande du convertisseur de fréquence.

10. Agencement selon la revendication 7, 8 ou 9,

**caractérisé en ce que**, dans l'agencement,

pendant le fonctionnement normal, le signal de sortie ($U_{2C}$) du contrôleur du composant est réglé pour suivre un signal de commande de fonctionnement normal ($V_{2(ON)}$),

dans une situation de défaut, un signal de commande de situation de défaut ($V_{2(FLT)}$) est réglé pour être actif, auquel cas l'agencement sélectionne le niveau de tension décroissant en tant que référence, qui peut être amplifié davantage en le signal de sortie ($U_{2C}$) du contrôleur, et

dans lequel, à la fin des deux signaux de commande après une période de temps déterminée, le signal de sortie ($U_{2C}$) du contrôleur peut être commandé au niveau négatif de l'état non conducteur.

11. Agencement selon l'une quelconque des revendications 7 à 10,

**caractérisé en ce que** l'appareil de l'agencement est un convertisseur de fréquence PWM, dans lequel il y a un pont de réseau (10) pour redresser la tension alternative triphasée du réseau d'alimentation en la tension continue ($U_{DC}$) du circuit intermédiaire, un condensateur de filtrage (CDC) dans le circuit intermédiaire continu, un pont de charge (11), par lequel la tension de sortie peut être formée à partir de la tension continue du circuit intermédiaire, ainsi qu'une unité de commande (12), et dans lequel au moins le pont de charge et de préférence également le pont de réseau comprennent des commutateurs de phase mis en oeuvre par des composants semi-conducteurs de puissance commandés par tension de grille (V2).

FIG. 1

FIG. 2

FIG. 3

FIG. 4

Collector-Emitter voltage   $V_{CE}$   (V)

FIG. 5

FIG. 6

FIG. 7

FIG. 8

**EP 1 988 632 B1**

### REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5986484 A
- US 6275093 B